(19) Europäisches Patentamt
European Patent Office
Office européen des brevets

(11) **EP 3 390 686 B1**

(12) **FASCICULE DE BREVET EUROPEEN**

(45) Date de publication et mention de la délivrance du brevet:
**20.11.2019 Bulletin 2019/47**

(21) Numéro de dépôt: **16831495.3**

(22) Date de dépôt: **17.12.2016**

(51) Int Cl.:
**B01D 8/00** *(2006.01)*    **C23C 16/448** *(2006.01)*
**C23C 16/32** *(2006.01)*    **C23C 16/18** *(2006.01)*
**B01D 5/00** *(2006.01)*    **C23C 16/44** *(2006.01)*

(86) Numéro de dépôt international:
**PCT/FR2016/053541**

(87) Numéro de publication internationale:
**WO 2017/103546 (22.06.2017 Gazette 2017/25)**

(54) **PROCEDE DE DEPOT D'UN REVETEMENT PAR DLI-MOCVD AVEC RECYCLAGE DIRECT DU COMPOSE PRECURSEUR.**

VERFAHREN ZUR ABSCHEIDUNG EINER BESCHICHTUNG MITTELS DLI-MOCVD MIT DIREKTEM RECYCLING DER VORLÄUFERVERBINDUNG

METHOD FOR DEPOSITING A COATING BY DLI-MOCVD WITH DIRECT RECYCLING OF THE PRECURSOR COMPOUND

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2015 FR 1562862**

(43) Date de publication de la demande:
**24.10.2018 Bulletin 2018/43**

(73) Titulaires:
• **Commissariat à l'Énergie Atomique et aux Énergies Alternatives
75015 Paris (FR)**
• **Institut National Polytechnique de Toulouse
31029 Toulouse (FR)**
Etats contractants désignés:
**FR**

(72) Inventeurs:
• **SCHUSTER, Frédéric
78100 St Germain-en-Laye (FR)**
• **MAURY, Francis
31670 Labege (FR)**
• **MICHAU, Alexandre
31400 Toulouse (FR)**
• **PONS, Michel
38700 La Tronche (FR)**
• **BOICHOT, Raphaël
38420 Domene (FR)**
• **LOMELLO, Fernando
91190 Gif-sur-Yvette (FR)**

(74) Mandataire: **Dennemeyer & Associates S.A.
Postfach 70 04 25
81304 München (DE)**

(56) Documents cités:
**EP-A1- 1 664 379      WO-A1-2008/009714
WO-A1-2008/009715    WO-A2-2007/106462**

**Description**

**DOMAINE TECHNIQUE**

La présente invention appartient au domaine des traitements pour la protection de pièces de structure travaillant en conditions sévères contre l'usure, la corrosion et/ou l'oxydation haute température. Elle se rapporte plus particulièrement à un procédé de dépôt chimique en phase vapeur de revêtements sur des surfaces à protéger.

Elle a pour objet un procédé de dépôt par voie sèche de couches métalliques ou céramiques sous pression réduite et à basse température, par injection directe dans un réacteur d'une solution de précurseur moléculaire d'un métal à déposer, l'effluent de la réaction étant collecté pour alimenter ledit procédé avec une solution de précurseur recyclée.

**ARRIERE-PLAN TECHNIQUE**

L'industrie mécanique (outillage, équipements industriels, automobile, aéronautique, ...) et l'industrie électronique (semi-conducteurs, photovoltaïque), ont un besoin croissant de matériaux qui résistent à des conditions sévères de production et/ou d'utilisation. Pour améliorer leur résistance et prolonger leur durée de vie, des pièces en céramiques, aciers ou alliages sont revêtues d'une couche d'une épaisseur de quelques microns composée d'un matériau céramique non-oxyde de type carbure, nitrure ou carbonitrure ou d'un élément métallique seul ou allié. Ce revêtement améliore les propriétés mécaniques de ces pièces, ainsi que leur résistance à l'usure et à la corrosion. Il peut être réalisé sous une forme monolithique ou nanostructurée en multicouches de même nature ou non.

Les revêtements à base de chrome ou d'autres métaux de transition aux propriétés voisines sont largement utilisés pour la protection de pièces contre l'usure et la corrosion. Dans l'industrie électronique, les revêtements déposés sont des films plus minces encore, qui apportent la propriété fonctionnelle indispensable au système.

Différentes techniques peuvent être mises en œuvre pour réaliser ces revêtements. Pendant longtemps, les revêtements métallurgiques (métaux, carbures, nitrures, ...), notamment à base de chrome, ont été essentiellement obtenus par la méthode d'électroplaquage en bain (ou galvanoplastie). Ce procédé était facile à mettre en œuvre pour le traitement au défilé à très basse température (inférieure à 100 °C) de pièces de toutes tailles, mais il donnait des revêtements microfissurés et fragiles vis-à-vis de la corrosion. Surtout, les procédés de dépôt par voie humide ont été proscrits en 2007 par les normes environnementales européennes du fait des effets cancérigènes des solutions de chrome hexavalent qu'ils utilisaient. Quant aux méthodes employant du chrome trivalent, encore utilisées actuellement, elles devraient aussi être interdites prochainement.

Des techniques alternatives de dépôt par voie sèche, dites propres, ont été proposées parmi lesquelles on trouve les techniques de dépôt chimique, telles que le dépôt chimique en phase vapeur (connu sous l'acronyme anglais CVD, pour "Chemical Vapor Deposition"), qui sont maîtrisées et déjà utilisées en production de certains revêtements.

On connaît par exemple le dépôt chimique en phase vapeur d'un métal, de nitrures, carbures ou carbonitrures d'éléments métalliques, à partir d'un cément constitué d'une poudre métallique en contact avec un composé réducteur volatil. Ce procédé fonctionne à pression atmosphérique, mais les dépôts sont obtenus uniquement à haute température du fait de la source métallique de type halogénure employée. Les procédés CVD classiques utilisent les vapeurs de l'halogénure directement comme source de métal et fonctionnent quant à eux sous vide dynamique et à haute température (de l'ordre de 1000 °C).

Du point de vue des conditions environnementales et de sécurité, l'utilisation de précurseurs halogénures thermiquement robustes, toxiques, corrosifs et de volatilité limitée, qui sont mis en œuvre à des températures de dépôt élevées, constitue un inconvénient majeur de ces procédés. En outre, les conditions thermiques sévères limitent la variété possible des substrats à revêtir.

Pour abaisser les températures de dépôt, des précurseurs moléculaires organométalliques ont été utilisés (procédé dit MOCVD, selon l'acronyme anglais pour "Metal Organic CVD") décrits plus en détail ci-après. Toutefois, compte tenu de la faible volatilité et de l'instabilité thermique de ces composés qui sont souvent des poudres, il est nécessaire d'opérer sous pression réduite. Le chauffage prolongé du précurseur dans la zone de sublimation (si c'est un solide) ou de vaporisation (si c'est un liquide), même à faible température, peut dégrader le réactif avant son arrivée à la zone de dépôt, entraînant ainsi des problèmes de reproductibilité pour le débit de précurseur, la composition gazeuse réactive initiale et donc la qualité de dépôt.

Ces difficultés ont été surmontées grâce à un procédé combinant le principe du dépôt chimique en phase vapeur et l'injection liquide d'un précurseur organométallique du composé métallique à déposer, appelé DLI-MOCVD selon l'acronyme anglais pour "Direct Liquid Injection - Metal Organic Chemical Vapor Deposition".

Ce procédé DLI-MOCVD présente l'avantage de fonctionner à basse température et sous pression réduite (ou même à pression atmosphérique), mais impose des conditions réactionnelles bien particulières pour le dépôt de couches de protection à base d'un métal ou d'un carbure de ce métal, ayant les caractéristiques d'homogénéité et de robustesse requises. On peut se reporter à ce sujet aux techniques décrites dans WO 2008009714 pour ce qui concerne les revêtements durs d'éléments métalliques (chrome ou autres métaux de transition), ainsi qu'à celles décrites dans WO 2008009715 pour ce qui concerne le dépôt de revêtements de type céramique non oxyde d'éléments métalliques.

Ces méthodes de synthèse dynamique (systèmes ouverts) présentent des avantages certains, mais elles mettent en œuvre des réactifs (tels que des halogénures, hydrures, hydrocarbures, composés organométalliques, ...), qui sont loin d'être consommés en totalité au cours de la réaction. Les réactifs, le solvant et leurs sous-produits se retrouvent ainsi en sortie du réacteur, obligeant les industriels à prendre des mesures pour traiter ces effluents gazeux et liquides. Ceci représente un gaspillage de produits élaborés que les préoccupations environnementales réprouvent, ainsi qu'une perte économique significative.

Ces pertes sont d'autant plus importantes que pour obtenir une bonne qualité des revêtements en termes d'uniformité d'épaisseur, de microstructure (notamment de densité) conférant les propriétés de résistance requises, des vitesses de dépôt modérées doivent être mises en œuvre. Les rendements du procédé sont alors relativement faibles.

Or, la conception de procédés industriels respectueux de l'environnement est l'un des objectifs majeurs de la recherche actuelle, répondant notamment aux directives européennes établies lors du sommet de Göteborg en 2001. Le développement des procédés CVD, et tout particulièrement DLI-MOCVD, est ainsi tributaire de leur impact environnemental (rejet des effluents, par exemple gaz, solvant, métaux lourds) et de leur impact économique (coût énergétique, des précurseurs - notamment les composés organométalliques -, des substrats, ...).

Les procédés CVD qui utilisent des volumes importants de gaz et de composés organiques et organométalliques complexes sont concernés.

Partant de ce constat, plusieurs pistes peuvent être envisagées pour agir sur la consommation énergétique, sur la consommation des précurseurs moléculaires, et sur celle des gaz, qu'ils soient des gaz porteurs assurant une bonne hydrodynamique dans le réacteur ou des réactifs.

La première piste, actuellement la plus explorée, est une optimisation du rendement jouant sur les paramètres du procédé DLI-MOCVD pour réduire les temps de dépôt. Cependant, les exigences de qualité des revêtements sont si fortes et si sensibles aux conditions de dépôt que les fenêtres de variation des paramètres de production sont trop étroites pour concilier toutes les contraintes.

La seconde piste serait de réduire la consommation des réactifs et des gaz de procédé (gaz utilisés dans le procédé, mais n'intervenant pas comme réactif, tel qu'un gaz vecteur). Les tentatives de modifier les conditions réactionnelles pour réduire la quantité de réactifs injectée dans le réacteur n'ont malheureusement pas permis d'obtenir les revêtements souhaités. Pour les raisons citées précédemment, les possibilités de faire varier les paramètres du procédé sont là encore fort réduites.

Pour répondre à ce défi, les auteurs de la présente invention ont imaginé non pas de modifier les conditions réactionnelles en tant que telles en réduisant la quantité totale de réactifs injectés dans le réacteur, mais de réutiliser les composés rejetés en sortie de réacteur, afin de les recycler dans le processus.

Des procédés de CVD mettant en œuvre une étape de recyclage ont déjà été proposés. On connaît par exemple des procédés CVD où un substrat graphène/Cu est recyclé, le métal étant également le catalyseur (Wang, Y., et al., ACS Nano, 2011. 5(12): p. 9927-9933). On connaît aussi la récupération des métaux précieux utilisés en électronique (Pt, Ru, Au...) dans les effluents, sous forme soit de métaux, soit de précurseurs recyclés pour un usage ultérieur, après les traitements chimiques appropriés (International, R. 2010; accessible sur le site http://www.recyclinginternational.com /recycling-news/3464/research-and-legislation/japan/japanese - recycling-process-ruthenium-precursors). Ces solutions technologiques qui visent l'abaissement du coût global, sont très limitées et ne sont pas applicables en DLI-MOCVD.

Des solutions ont été proposées pour certains procédés CVD consommant de grandes quantités de gaz et de réactifs, par exemple pour la production industrielle de nanotubes de carbone. Le mélange relativement simple d'hydrocarbures $H_2/C_2H_4$ ne produit pas moins de 45 sous-produits, dont des Composés Organiques Volatils (COV) et des Hydrocarbures Aromatiques Polycycliques (HAP) (Plata, D.L., et al., Environmental Science & Technology, 2009. 43(21): p. 8367-8373). Si le piégeage et le recyclage de ces composés permettent leur usage ultérieur, c'est au prix d'un traitement complexe et coûteux, réalisé en parallèle du procédé de dépôt CVD en vue d'un recyclage indirect de ces composés, mais pas directement dans le procédé lui-même, par exemple en boucle fermée ou semi fermée avec réinjection des composés dans le réacteur CVD.

Des systèmes de recyclage sont également utilisés dans la production de masse par CVD du silicium polycristallin pour les applications photovoltaïques et microélectroniques. On connaît par exemple l'effet bénéfique du recyclage en boucle sur l'uniformité d'épaisseur des films de silicium polycristallin obtenus dans un réacteur tubulaire par CVD basse pression utilisant le mélange réactif $SiH_4/H_2$. L'épaisseur du film est d'autant plus uniforme que les gaz sont continûment et parfaitement agités, ce que le recyclage contribue à réaliser (Collingham, M.E. et al., Journal of the Electrochemical Society, 1989. 136(3): p. 787-794).

Pour l'industrie solaire, le procédé CVD utilise $SiCl_4$ et $H_2$ en large excès, un convertisseur transformant $SiCl_4$ en $HSiCl_3$ pour une croissance plus rapide de Si. Seulement 20 % de $HSiCl_3$ est consommé et des sous-produits sont formés (chlorosilanes, HCl, $H_2$). Les effluents sont collectés, séparés et stockés pour un autre usage, tandis que $HSiCl_3$

non consommé est recyclé dans le procédé (Project, P.P. 2010; Vent Gas Recovery and Recycle Process Technology Package, accessible sur le site : www.polyplantproject.com/offgasrecoveryrecycling.html). Avec ce procédé CVD aux chlorures, un système en boucle quasi fermée a été proposé en jouant sur l'équilibre décapage/dépôt du système chimique et en s'appuyant sur la simulation thermodynamique et cinétique (Noda, S., et al., Conference Record of the Twenty-Ninth IEEE. 2002). D'autre part, le recyclage de $H_2$ via un système intégré dans un procédé utilisant $SiH_4/H_2$ a été récemment mis au point (Revankar, V. and S. Lahoti, 2015, Savi Research, Inc.).

Toutefois, dans toutes les technologies de dépôt de silicium par CVD présentant un recyclage en boucle, les sous-produits de réaction sont en petit nombre. Ce sont des hydrures dérivés de $SiH_4$, des halogénures dérivés de $SiCl_4$, ou des hydrocarbures issus de $CH_4$ dans le cas du dépôt de carbone qui sont tous gazeux à la température de travail et ont le même comportement thermique que le précurseur initial. Ils constituent des sources réactives pour le dépôt qui n'affectent pratiquement pas le mécanisme de croissance ni la cinétique de réaction.

Le document WO 2007106462 propose de recycler au moins une partie des effluents produits par un procédé de dépôt MOCVD tout en préconisant une étape de purification de ces effluents qui vise en particulier à séparer les précurseurs organométalliques n'ayant pas réagi des sous-produits de la réaction.

Il apparaît ainsi qu'aucun procédé ne prévoit à ce jour le recyclage satisfaisant des composés impliqués dans des procédés de dépôt de films par DLI-MOCVD. Du fait de leur grande réactivité et de la complexité du mécanisme de décomposition des précurseurs organométalliques, des sous-produits nombreux et très différents sont générés. On s'attend à ce que le produit recyclé ne réponde pas aux conditions requises initialement, et que la pureté, la microstructure et la cinétique de croissance des revêtements en soient significativement affectées.

## EXPOSE DE L'INVENTION

Un des buts de l'invention est donc d'éviter ou d'atténuer un ou plusieurs des inconvénients décrits ci-dessus, et en particulier de réduire, voire d'éliminer, l'usage, la génération et le rejet de substances néfastes pour l'environnement, lors de la réalisation de revêtements de protection sur des pièces mécaniques ou autres.

Dans ce cadre, un objectif de l'invention est de proposer un procédé de dépôt chimique respectueux de l'environnement, en évitant au mieux la production de déchets issus des réactions de dépôt chimique plutôt que d'investir dans leur élimination.

Un autre objectif de l'invention est d'offrir un procédé de dépôt qui minimise les contraintes industrielles et les besoins énergétiques, de manière à limiter l'impact économique et environnemental du procédé.

Un autre objectif de l'invention est de réutiliser les composés formés et/ou non consommés.

Ces objectifs sont recherchés, moyennant le maintien sinon l'amélioration, de la qualité et des performances des revêtements obtenus avec les technologies conventionnelles.

Pour répondre à un ou plusieurs de ces objectifs, l'invention a pour objet un procédé de dépôt d'un revêtement protecteur sur un substrat selon la technique de DLI-MOCVD, procédé dans lequel certains effluents présents en sortie de réacteur sont collectés, puis recyclés dans le procédé de dépôt sans dégrader ses performances ou la qualité des dépôts.

La présente invention concerne ainsi un procédé de dépôt sur un substrat d'un revêtement protecteur composé d'une ou de plusieurs couches, l'une au moins étant une couche protectrice comprenant un métal de transition M sous forme d'au moins une matière protectrice choisie parmi un carbure, un alliage ou un métal, le procédé de dépôt étant un procédé de dépôt chimique en phase vapeur d'un composé organométallique par injection liquide directe (DLI-MOCVD) qui comprend les étapes suivantes :

a) disposer dans un réservoir d'alimentation d'une solution mère contenant :

- un solvant hydrocarboné dépourvu d'atome d'oxygène,
- ledit composé organométallique constitué d'un précurseur de type bis(arène) ayant une température de décomposition comprise entre 300 °C et 600 °C et comprenant le métal de transition M, et
- le cas échéant un inhibiteur d'incorporation de carbone ;

b) vaporiser ladite solution mère dans un évaporateur puis l'introduire dans un réacteur de dépôt chimique en phase vapeur dans lequel se trouve ledit substrat à recouvrir ; pour réaliser, dans l'enceinte du réacteur dont l'atmosphère est à une température de dépôt comprise entre 300 °C et 600 °C sous pression de dépôt réduite, le dépôt de la couche protectrice sur ledit substrat ;

c) collecter en sortie du réacteur une fraction de l'effluent gazeux comprenant le précurseur non consommé, les sous-produits aromatiques du précurseur et le solvant, ces espèces formant ensemble dans les conditions standards une solution fille, et ;

d) déverser la solution fille ainsi obtenue dans le réservoir d'alimentation pour obtenir une nouvelle solution mère apte à être utilisée à l'étape a).

## EXPOSE DETAILLE DE L'INVENTION

Dans la présente description de l'invention, un verbe tel que "comprendre", "incorporer", "inclure", "contenir", "composé de" et ses formes conjuguées sont des termes ouverts et n'excluent donc pas la présence d'un ou plusieurs éléments ou d'étapes supplémentaires s'ajoutant aux éléments ou étapes initiaux énoncés après ces termes. Ces termes ouverts visent en outre un mode de réalisation particulier dans lequel seul(s) le(s) élément(s) et/ou étape(s) initiaux, à l'exclusion de tout autre, sont visés ; auquel cas le terme ouvert vise en outre le terme fermé "consister en", "constituer de" et ses formes conjuguées.

L'usage de l'article indéfini "un" ou "une" pour un élément ou une étape n'exclut pas, sauf mention contraire, la présence d'une pluralité d'éléments ou étapes.

Par ailleurs, sauf indication contraire, les valeurs aux bornes sont incluses dans les gammes de paramètres indiquées.

Toujours dans la présente description, tout alliage est en général un alliage de base. On désigne par « alliage de base » du métal entrant notamment dans la composition de la couche protectrice ou du substrat à recouvrir, tout alliage à base du métal dans lequel la teneur du métal est au minimum de 50 % en poids du métal de l'alliage, particulièrement plus de 90 %, voire plus de 95 %. Le métal de base est plus particulièrement un métal de transition M, choisi de préférence parmi Cr, Nb, V, W, Mo, Mn ou Hf, qui forme l'alliage de base correspondant du métal de transition M.

Un alliage peut également contenir d'autres éléments chimiques (par exemple à une teneur supérieure à 0,5 % atomique), en particulier un deuxième élément métallique (tel que par exemple un deuxième métal de transition M) afin de constituer un alliage mixte.

L'élément carbone en insertion dans un alliage forme un carbure de l'alliage qui peut aussi être mixte en présence d'un deuxième élément métallique (par exemple un deuxième métal de transition M).

Le procédé de dépôt selon l'invention comprend essentiellement des étapes de dépôt a) et b) et des étapes de recyclage c) et d).

Les étapes de dépôt sont réalisées selon la technique de DLI-MOCVD. Cette méthode est décrite par exemple dans les documents suivants : « F. Maury, A. Douard, S. Delclos, D. Samelor, C. Tendero; Multilayer chromium based coatings grown by atmospheric pressure direct liquid injection CVD Surface and Coatings Technology, 204 (2009) 983-987 »), « A. Douard, F. Maury ; Nanocrystalline chromium-based coatings deposited by DLI-MOCVD under atmospheric pressure from Cr(CO)6 ; Surface and Coatings Technology, 200 (2006) 6267-6271 », WO 2008009714 et WO 2008009715.

Le réacteur CVD utilisé dans la technique de DLI-MOCVD est généralement un réacteur à parois chaudes, classiquement utilisé dans ce domaine et opérant sous pression réduite. Le réacteur dans son ensemble est chauffé à la température requise pour le dépôt, de sorte que les parois, la phase gazeuse réactive circulant dans le réacteur et donc l'atmosphère du réacteur, et le substrat à recouvrir sont à la même température. Ce type de réacteur est aussi appelé "isotherme" (ou "quasi isotherme" lorsque quelques gradients de température subsistent).

Un réacteur à parois froides peut aussi être utilisé. Dans le réacteur à paroi froide, seul le substrat est chauffé, si bien que la réaction n'est effective qu'au niveau du substrat chauffé. Le rendement du réacteur déterminé à partir de la consommation en précurseur est alors faible, ce qui accroît l'intérêt d'un recyclage des réactifs.

Le principe de la technique DLI-MOCVD est d'introduire directement dans l'enceinte du réacteur de dépôt chimique en phase vapeur, en régime continu ou pulsé, un précurseur du métal à déposer sous forme vaporisée. Pour ce faire, une solution moléculaire du précurseur métallique est introduite dans un évaporateur à partir d'un réservoir d'alimentation sous pression (par exemple sous 3 bars de gaz inerte ($N_2$), soit $3.10^5$ Pa) contenant ledit précurseur dans un solvant. Cette solution mère est fractionnée en microgouttelettes pour former un aérosol qui est vaporisé de façon flash. L'évaporation "flash" consiste à vaporiser de manière rapide un composé en dehors des conditions de pression et de température prévues par sa loi de pression de vapeur saturante. L'évaporateur est chauffé à une température telle que le précurseur et son solvant sont vaporisés, sans toutefois provoquer de décomposition à ce stade. La température de vaporisation est généralement comprise entre la température d'ébullition du solvant et la température de décomposition du précurseur (et accessoirement du solvant), typiquement entre 100 °C et 250 °C, par exemple autour de 150 °C voire 200 °C.

Les paramètres d'injection de la solution de précurseur sont de préférence fixés à l'aide d'un programme informatique. Ils sont ajustés de manière à obtenir un brouillard de gouttelettes très fines et nombreuses, afin d'obtenir une évaporation flash satisfaisante sous pression réduite. L'injection liquide constitue ainsi une source bien contrôlée de précurseur organométallique, ce qui ne limite pas les possibilités d'optimisation des paramètres du procédé de dépôt du revêtement.

Le précurseur et le solvant vaporisés sont entraînés par un flux de gaz neutre (ou de manière générale un gaz inerte chimiquement vis-à-vis des espèces chimiques présentes dans le réacteur CVD) de l'évaporateur vers la zone de dépôt du réacteur. Le substrat à recouvrir repose ou non sur un porte-échantillon placé dans le réacteur. Le gaz vecteur utilisé est de préférence préchauffé au maximum à la température de l'évaporateur, pour obtenir une vaporisation efficace. L'azote est généralement choisi pour son faible coût, mais l'hélium bénéficiant d'une meilleure conductivité thermique ou l'argon dont le pouvoir de protection est supérieur peuvent aussi être employés.

Selon le procédé de l'invention, le métal de transition M à déposer est typiquement le chrome, ou tout autre métal dont la chimie et la métallurgie sont apparentées à celles du chrome. L'homme du métier connaît les éléments pour lesquels on obtient les propriétés de dureté et d'inertie chimique requises en métallurgie. Le métal de transition M est par ailleurs susceptible de former un composé bis(arène).

Ainsi, selon l'invention, le métal de transition M à déposer peut être choisi parmi Cr, Nb, V, W, Mo, Mn ou Hf ; éventuellement au degré d'oxydation zéro. Plus particulièrement, le métal de transition est choisi parmi Cr, Nb, V, ou Mo car leurs carbures sont très stables.

Les dépôts réalisés sont généralement des revêtements céramiques (par exemple de type carbure) ou métalliques (métal ou alliage). Le métal de transition M préserve le plus souvent son degré d'oxydation dans le revêtement protecteur déposé, car le précurseur se décompose thermiquement sans réaction complexe telle que par exemple une réaction d'oxydoréduction qui génère de nombreux sous-produits.

De préférence, le métal de transition M (plus particulièrement le chrome) est au degré d'oxydation zéro dans le précurseur de type bis (arène) et également dans la matière protectrice déposée par le procédé de l'invention. En effet, dans le cas particulier des carbures par exemple, ces derniers étant des carbures d'insertion, le métal de transition M préserve généralement le degré d'oxydation zéro.

La solution mère mise en œuvre dans le procédé de dépôt de l'invention contient un précurseur de type bis(arène) contenant le métal de transition M, un solvant hydrocarboné dépourvu d'atome d'oxygène, et le cas échéant un inhibiteur d'incorporation de carbone.

Le composé organométallique précurseur est un composé moléculaire dans lequel un métal de transition M, destiné à réagir pour former un revêtement protecteur sur le substrat, est complexé à des ligands organiques qui sont deux groupes arènes afin de former un précurseur de type bis(arène). Ces ligands confèrent au précurseur la stabilité thermique voulue dans la plage de températures choisie. Lorsque la couche protectrice comprend plusieurs métaux de transition M (par exemple dans le cas d'un carbure mixte ou d'un alliage), la solution mère comprend un mélange des précurseurs de type bis(arène) comprenant chacun son propre métal de transition M.

Selon l'invention, le précurseur est de préférence un composé sandwich de type bis(arène) dépourvu d'atome d'oxygène, de formule générale (Ar)(Ar')M où M est le métal de transition M au degré d'oxydation zéro ($M_0$) et Ar, Ar', identiques ou différents, représentent chacun un groupe aromatique de type benzène ou benzène substitué par au moins un groupe alkyl.

La stabilité de la liaison métal-ligand augmente sensiblement avec le nombre de substituants du noyau benzénique. Afin de favoriser la décomposition du précurseur, un précurseur dans lequel Ar et Ar' représentent deux ligands aromatiques faiblement substitués peut être choisi. Ainsi, selon l'invention, les groupes aromatiques Ar et Ar' représentent de préférence chacun un radical benzène, ou benzène substitué par un à trois groupes identiques ou différents, choisis parmi un groupe méthyl, éthyl, ou isopropyl.

De manière particulièrement intéressante, il est apparu que la solution mère pouvait fournir à la réaction des précurseurs différents sans influencer négativement le procédé. En particulier, la nature exacte des ligands aromatiques du métal de transition M n'est pas critique, sous réserve que ces ligands appartiennent à la même famille chimique des aromatiques monocycliques faiblement substitués. Avantageusement, la réintroduction dans le réacteur de sous-produits de la réaction CVD dérivés des réactifs initiaux est alors possible, et ce même si les produits collectés en sortie de réacteur ont des structures chimiques différentes. La pureté de la solution mère initiale n'est pas non plus un point critique, ce qui permet d'utiliser des solutions commerciales qui peuvent contenir jusqu'à 10 % de composés dérivés. Un recyclage de ces composés dérivés dans le procédé lui-même étant possible, les solutions mères recyclées qui seront utilisées pour un dépôt ultérieur contiendront différents bis(arène) à titre de précurseurs.

Ainsi, selon une caractéristique préférée de l'invention, ladite solution mère peut contenir un mélange de plusieurs précurseurs de type bis(arène) comprenant le métal M, de formules générales (Ar) (Ar')M différentes, en particulier de formules générales (Ar)(Ar')$M_0$ différentes.

A titre d'exemple, lorsque le métal est le chrome, en particulier au degré d'oxydation zéro, le précurseur peut être un composé sandwich du chrome, tel que le bis (benzène) chrome (dit BBC, de formule $Cr(C_6H_6)_2$), le bis (éthylbenzène)chrome (dit BEBC, de formule $Cr(C_6H_5Et)_2$), le bis (méthylbenzène) chrome (de formule $Cr(C_6H_5Me)_2$), et le bis(cumène)chrome (de formule $Cr(C_6H_5iPr)_2$), ou leur mélange. Il peut aussi être un dérivé dissymétrique de formule (Ar)(Ar')Cr où Ar et Ar' sont différents ; ou un mélange de ces bis(arène)chrome qui peut être riche en l'un de ces composés. Ces précurseurs se décomposent tous à partir d'environ 300 °C. Les précurseurs présentant une température de décomposition supérieure à 600 °C sont écartés, afin d'éviter la décomposition du solvant pour les raisons expliquées plus loin. Les formules chimiques des précurseurs de chrome qui précèdent sont transposables aux précurseurs comprenant le métal de transition M en y remplaçant le chrome par un des autres métaux de transition M en particulier au degré d'oxydation zéro. Le précurseur de type bis (arène) comprenant l'élément $M_0$ peut ainsi être choisi parmi au moins un composé de formule $M_0(C_6H_6)_2$, $M_0(C_6H_5Et)_2$, $M_0(C_6H_5Me)_2$ ou $M_0(C_6H_5iPr)_2$.

Seul le BBC se présente sous la forme d'une poudre. Il peut être injecté sous la forme d'une solution, mais la concentration est alors rapidement limitée par sa faible solubilité dans les solvants hydrocarbonés.

Les autres précurseurs cités à titre d'exemple sont liquides et peuvent être directement injectés sans solvant, mais le contrôle de la microstructure des dépôts est alors plus difficile. Leur usage en solution est donc préféré, car cela permet une large variation de la concentration de ladite solution mère, un meilleur ajustement des conditions d'injection et en conséquence des propriétés physiques.

La concentration dans la solution mère du précurseur de type bis (arène) comprenant le métal de transition M peut être comprise entre 0,1 mol.L$^{-1}$ et 4,4 mol.L$^{-1}$ (concentration du précurseur pur), généralement entre 0,1 mol.L$^{-1}$ à 1 mol.L$^{-1}$, typiquement 0,35 mol.L$^{-1}$.

Le solvant du composé précurseur joue un rôle important dans la bonne réalisation du procédé de dépôt selon l'invention. Il répond de préférence à l'ensemble des critères chimiques et physiques suivants :

- son point d'ébullition est inférieur à la température de l'évaporateur pour permettre une évaporation flash dans l'évaporateur.
- il ne contient pas d'oxygène pour éviter l'oxydation des dépôts par craquage du solvant employé dans la zone de dépôt.
- il est inerte chimiquement vis-à-vis du précurseur en solution et liquide dans les conditions standards de pression et de température. Dans la présente description, les conditions standards sont la pression atmosphérique et une température de 25 °C.
- il solubilise efficacement les précurseurs dont il est proche chimiquement quand il est de nature aromatique.
- il ne se décompose pas significativement dans le réacteur, afin de limiter au mieux toute pollution dans l'objectif de récupérer le solvant dans l'effluent en sortie du réacteur.

Ainsi, le solvant est de préférence un hydrocarbure aromatique monocyclique de formule générale $C_xH_y$, liquide dans les conditions standards, ayant une température d'ébullition inférieure à 150 °C et une température de décomposition supérieure à 600 °C.

Le solvant appartient avantageusement à une famille chimique proche de celle des ligands du composé précurseur, à savoir la famille des hydrocarbures aromatiques également appelés « arènes ». En effet, durant le passage dans le réacteur, le précurseur se décompose thermiquement, libérant ses ligands les uns après les autres. Les sous-produits de la réaction sont donc essentiellement des arènes libres qui se mélangent d'autant mieux au solvant qu'ils en sont chimiquement proches voire identiques. De ce fait, les composés collectés dans l'effluent en sortie de réacteur (précurseur, sous-produits de la réaction CVD et solvant) sont en général tous des hydrocarbures aromatiques. Des sous-produits aliphatiques du type alcane/alcène comprenant 2 à 4 atomes de carbone et qui proviennent de la décomposition du solvant aromatique sont probablement présents en faible quantité. Comme détaillé plus loin, ces composés qui sont gazeux dans les conditions standards, ne seront pas collectés à l'étape c) du procédé, contrairement aux composés collectés qui sont quant à eux liquides.

Ainsi, selon l'invention, le solvant est de préférence choisi parmi le benzène, ou le benzène substitué par un ou plusieurs groupes, identiques ou différents, choisis parmi un groupe méthyl, éthyl, ou isopropyl.

Selon un mode de réalisation particulièrement préféré de l'invention, le solvant est le benzène, le toluène, l'éthylbenzène, le mésitylène (1,3,5-triméthylbenzène) ou leurs mélanges. En pratique toutefois, le benzène est exclu en raison de sa toxicité élevée, notamment en tant que cancérogène avéré.

Lorsque l'on souhaite obtenir le dépôt d'un revêtement métallique dur (à savoir de type métal ou alliage) sur le substrat, un inhibiteur d'incorporation de carbone est de préférence ajouté dans la solution mère, par exemple à une concentration égale à 1 % à 10 % de la concentration molaire dans la solution mère du précurseur de type bis(arène), par exemple 2 %.

Cet additif, de préférence un additif chloré ou soufré, a pour fonction d'empêcher ou de limiter la décomposition hétérogène des ligands aromatiques du précurseur. En effet, lors de la dissociation des liaisons métal-ligand, une partie des ligands hydrocarbures se décomposent sous l'effet catalytique de la surface du substrat et apportent leurs carbones, qui se lient avec le métal de transition pour former des céramiques de type carbure ou carbure mixte. Une faible quantité de carbone peut également être déposée avec le métal de transition M au cours de l'étape b), sans pour autant former un carbure, même en présence de l'inhibiteur.

C'est pourquoi, dans une variante d'exécution du procédé selon l'invention, ladite solution mère contient en outre un additif chloré ou soufré, dépourvu d'atome d'oxygène et dont la température de décomposition est supérieure à 600 °C, afin d'obtenir la matière protectrice composée du métal de transition M ou de l'alliage du métal de transition M. Dans les conditions standards, cet additif est par ailleurs miscible dans la solution mère.

Comme indiqué précédemment, il est avantageux que les composés introduits dans le réacteur puissent être recyclés (eux-mêmes ou leurs sous-produits) sans affecter la réaction de dépôt par DLI-MOCVD. L'additif est donc de préférence un hydrocarbure aromatique monocyclique substitué par un groupe thiol ou au moins un chlore. Plus préférentiellement, l'additif est le thiophénol ($C_6H_5SH$) ou l'hexachlorobenzène ($C_6Cl_6$).

Concernant les conditions de dépôt du procédé de l'invention, l'enceinte du réacteur est chauffée à une température de dépôt comprise entre 300 °C et 600 °C, afin de décomposer le précurseur de type bis(arène)métal, sans toutefois dégrader le solvant : cela évite ou tout du moins limite la production et le dépôt de sous-produits indésirables dans le réacteur et sur ses parois voire sur le substrat.

Si le substrat à recouvrir est métallique (composé par exemple d'un alliage ou d'un métal natif), la température de dépôt ne dépasse généralement pas la température au-delà de laquelle la tenue mécanique du substrat métallique se dégrade (par exemple une température de tenue de 550 °C). Cette précaution évite les déformations ou les transformations de phase éventuelles du substrat métallique.

Le réacteur est placé sous pression réduite pour réaliser les principales étapes du dépôt, depuis la vaporisation de la solution mère contenant le précurseur jusqu'à l'extraction de l'effluent à l'étape c) de collecte de la fraction de l'effluent gazeux. La pression réduite est généralement de quelques Torr à quelques dizaines de Torr. Ce sont donc de pressions modérément réduites au regard des pressions d'environ $10^{-3}$ Torr à $10^{-4}$ Torr des procédés PVD industriels qui nécessitent des équipements de vide poussé.

Ainsi, selon une caractéristique préférée de l'invention, l'étape b) de vaporisation et dépôt et l'étape c) de collecte de ladite fraction de l'effluent sont réalisées de telle sorte que l'atmosphère de l'enceinte du réacteur est à une pression de dépôt réduite comprise entre 1 Torr et 50 Torr (soit en unité SI, entre 133 Pa et 6666 Pa), et alternativement entre 13 Pa à 7000 Pa.

A l'issue des étapes a) et b) du procédé de dépôt de l'invention, un revêtement protecteur composé de la matière protectrice recouvre le substrat. Cette matière protectrice peut contenir un ou plusieurs métaux de transition M sous forme d'un carbure, d'un alliage ou d'un métal.

Le carbure du métal de transition M composant la matière protectrice est obtenu en absence d'inhibiteur d'incorporation de carbone dans la solution mère. Il peut s'agir d'un carbure de type CrC, WC, NbC, MoC, VC ou HfC, ou de formule stœchiométrique $Cr_7C_3$, $Cr_3C_2$, $Mo_2C$, $Mn_3C$, $V_2C$ ou $V_4C_3$. Lorsqu'elles ne comportent pas d'indices stœchiométriques (cas pour les carbures de type CrC, WC, NbC, MoC, VC ou HfC), ces dénominations ne correspondent pas à une formule stœchiométrique définie mais à une notation usuelle, car ces carbures du métal de transition M sont des carbures d'insertion dans lesquels la quantité de carbone peut varier dans des limites connues par l'homme du métier. Par exemple, CrC désigne de manière générale un carbure de chrome, qui peut également être noté « $CrC_x$ » : le coefficient x indique que le carbure n'a pas exactement la stœchiométrie d'un des trois composés de carbure de chrome stable ($Cr_{23}C_6$ ; $Cr_7C_3$ ; $Cr_3C_2$). Sa composition peut être proche de $Cr_7C_3$ mais intermédiaire à celle de $Cr_3C_2$.

Le carbure comprenant le métal de transition M peut également être un carbure d'un alliage du métal de transition M, éventuellement un carbure mixte, tel que mentionné dans la présente description.

L'alliage du métal de transition M composant la matière protectrice est de préférence un alliage de base du métal de transition M.

L'alliage du métal de transition M ou son alliage de base peut être tout alliage connu de l'homme du métier comprenant le métal de transition M choisi parmi Cr, Nb, V, W, Mo, Mn, Hf, ou leurs mélanges. De préférence, c'est un alliage à base de chrome choisi plus particulièrement parmi un alliage chrome/vanadium, un alliage chrome/niobium, un alliage chrome/vanadium/niobium, ou un alliage chrome/molybdène.

Un alliage du métal de transition M peut être obtenu en mélangeant différents précurseurs organométalliques dans la solution mère : par exemple, pour obtenir un alliage chrome/vanadium, la solution mère comprend un mélange d'un précurseur de type bis (arène) comprenant du chrome et d'un précurseur de type bis (arène) comprenant du vanadium, chaque précurseur étant par exemple présent dans la solution mère selon un rapport molaire entre ces deux précurseurs qui correspond au rapport stœchiométrique chrome/vanadium dans l'alliage chrome/vanadium correspondant.

Le métal composant la matière protectrice est généralement le métal de transition M sous forme native (ou quasiment pure) qui peut être de préférence le chrome, le vanadium, le niobium, ou le molybdène.

La matière protectrice comprenant le métal de transition M peut contenir des impuretés de fabrication. La nature et les teneurs de ces impuretés sont généralement les natures et teneurs typiques des impuretés des matières métalliques ou céramiques industrielles. Généralement, les teneurs des impuretés inévitables sont de moins de 200 ppm, préférentiellement moins de 100 ppm, encore plus préférentiellement moins de 50 ppm.

Les gaz qui traversent le réacteur sont ceux qui ont été introduits en amont. En sortie du réacteur, l'effluent gazeux comprend des molécules de précurseur, le solvant (et l'additif chloré ou soufré le cas échéant), qui n'ont pas été consommés ni pyrolysés. L'effluent comprend aussi des sous-produits aromatiques du précurseur, en particulier des ligands libres dissociés provenant du précurseur, qui sont de la même famille aromatique que le solvant. Ils s'intègrent dans le solvant de base avec lequel ils sont parfaitement miscibles, et jouent alors eux-mêmes le rôle de solvant.

De manière surprenante et particulièrement intéressante, la majorité des composés en sortie du réacteur à basse température sont des molécules aromatiques monocycliques, de structure chimique voisine ou identique à celle des composés initiaux que sont le précurseur ou le solvant. Il est donc intéressant de les recueillir, à savoir de les collecter au cours de l'étape c). Ils sont gazeux en sortie de réacteur du fait des conditions de température et de pression, mais liquides dans les conditions standards. Le mélange ainsi collecté forme une solution, dite solution fille, qui peut être introduite dans le réservoir d'alimentation du réacteur en tant que nouvelle solution mère apte à être utilisée à l'étape a) du procédé de revêtement.

Toutefois, l'effluent comprend aussi des composés dérivés des molécules aromatiques par fragmentation thermique, ainsi que des sous-produits de la réaction du précurseur avec le substrat. Ces fragments issus de la décomposition d'aromatiques en $C_6$ sont essentiellement des hydrocarbures aliphatiques légers de type alcane, alcène ou alcyne en $C_2$ à $C_4$. Pour collecter efficacement les composés destinés à former la solution fille, il est possible de mettre à profit la différence des températures de condensation entre les composés aromatiques et les hydrocarbures légers. Les espèces intéressantes (essentiellement les arènes donc) sont discriminables par leur point de fusion : elles peuvent donc être collectées à l'étape c) grâce à un dispositif apte à provoquer leur condensation dans un intervalle de températures prédéfini. Les hydrocarbures légers, bien qu'en quantité secondaire, peuvent alors être éliminés.

Ainsi, selon un mode de réalisation préférentiel de l'invention, à l'étape c), la collecte de ladite fraction en sortie du réacteur comprend une opération de condensation sélective des espèces présentes dans l'effluent en sortie du réacteur.

Un dispositif adapté pour capturer par condensation sélective le précurseur et le solvant non consommés, ainsi que les sous-produits aromatiques de la réaction CVD, est par exemple un piège cryogénique. Ce type de piège, qui peut descendre jusqu'à la température d'ébullition de l'azote liquide, consiste en une pièce forçant le passage de la phase gazeuse à travers une conduite suffisamment refroidie pour faire condenser ces espèces. Il peut être réglé dans une plage de températures appropriée pour condenser et solidifier les espèces gazeuses à recycler, de préférence entre -200 °C et -50 °C. La température dépend du bain cryogénique choisi (-100 °C avec un piège à l'éthanol surfondu et -200 °C environ avec un piège à l'azote liquide), et est ajustable (on peut se référer par exemple aux tables de données publiées dans l'ouvrage « Handbook of Chemistry and Physics, CRC Press »).

De préférence, selon l'invention, la condensation sélective des espèces présentes dans l'effluent est réalisé par un piégeage cryogénique à une température comprise entre -200 °C et -50 °C.

Cette opération de piégeage cryogénique se déroulant à la pression réduite régnant dans le système, il convient ensuite de casser le vide par une entrée de gaz inerte et de revenir à la température ambiante, ce qui peut être fait par une méthode connue de l'homme de l'art. On recueille ainsi une fraction liquide qui est la solution fille.

Ainsi, selon l'invention, ladite fraction condensée est ramenée aux conditions standards de température et de pression, et les espèces restant en phase liquide qui forment une solution fille sont conservées. Les espèces gazeuses sont quant à elles éliminées : en tant qu'hydrocarbures aliphatiques légers et très volatils, ils sont en effet beaucoup moins efficacement piégés que les autres espèces avec un piège cryogénique. Ils sont en partie éliminés lors de la condensation sélective. Puis, étant à l'état de gaz dans les conditions standards, ils sont facilement entrainés par la pompe à vide équipant le piège cryogénique.

Ceci présente un avantage important, puisqu'on piège l'essentiel de la matière de l'effluent pour le recycler. Le piégeage des espèces à recycler peut également se faire à des fins d'échantillonnage, par exemple pour effectuer des analyses ultérieures (diagnostic ex *situ*).

Les espèces de petite taille formées durant la réaction sont peu nombreuses en quantité et en nature. Il a été vérifié expérimentalement que les effluents piégés en sortie de réacteur sont un mélange a) de précurseur non consommé, b) de solvant de la solution mère qui n'a pas été pyrolysé, et c) de ligands libres, (avec éventuellement un additif chloré ou soufré). Quelques composés organiques dérivés de la décomposition des ligands peuvent être présents en quantités très faibles.

A l'issue de l'étape c) du procédé de l'invention, une solution fille caractérisée par un rapport précurseur/solvant certes plus faible que celui de la solution mère est obtenue, mais quasiment sans autre source organométallique susceptible d'affecter le mécanisme de dépôt. Ce résultat était imprévisible, car il est généralement admis que la décomposition des composés organométalliques tels que les précurseurs de type bis(arène) aboutit à la formation de nombreux sous-produits, dont certains peuvent se recombiner avec le métal libéré pour donner de nouveaux composés très différents dans leur comportement thermique notamment. Il est remarquable que, contrairement au cas général, tout le métal provenant de la décomposition du précurseur participe au dépôt du revêtement, sans réagir avec des composés formés dans le réacteur. Aucun dérivé organométallique nouveau n'est donc formé durant la réaction.

A l'issue d'une opération de dépôt (constitué essentiellement par les étapes a) et b) du procédé de dépôt de l'invention), la solution fille piégée peut être réutilisée dans une seconde opération de dépôt (mode discontinu), ou dans un système de recyclage en boucle pouvant être automatisé (mode continu).

En effet, la solution fille collectée contient le précurseur qui peut être réutilisé et recyclé dans le procédé de dépôt de l'invention, et ce même si la concentration finale du précurseur dans la solution fille est inférieure à sa concentration initiale dans la solution mère.

Afin de connaître cette concentration finale en précurseur dans la solution fille recueillie, une méthode spectro-colorimétrique suivie d'une comparaison à une droite étalon peut être utilisée, éventuellement sous forme d'un dispositif en ligne intégré à l'équipement de CVD.

Selon un mode de réalisation préféré de l'invention, l'étape c) de collecte de ladite fraction en sortie du réacteur est donc suivie d'une étape c1) de détermination de la concentration du précurseur dans la solution fille obtenue.

En fonction des résultats de cette détermination, la concentration en précurseur dans la solution mère peut être ajustée, par exemple pour moduler la vitesse de dépôt de la couche protectrice selon l'étape b) du procédé de dépôt de l'invention. Cet ajustement de concentration peut consister en un ajout de précurseur pur à la solution fille qui sera apportée pour reconstituer une solution mère, ou en un ajout de précurseur pur directement dans le réservoir d'alimentation pour compléter la nouvelle solution mère.

Ainsi, le procédé selon l'invention peut comprendre, à l'étape d), une opération d0) d'ajustement de la concentration en précurseur, en fonction de la concentration de la solution fille déversée dans le réservoir d'alimentation.

De manière alternative, on peut se fonder, non sur la concentration, mais sur la quantité de précurseur collectée. Dans ce cas, un volume de solution fille apportant la quantité désirée de réactif est introduit dans le réservoir d'alimentation. Cette dernière façon de procéder est commode. Elle est rendue possible par les tests réalisés montrant que la concentration en précurseur n'est pas un paramètre critique de la dynamique réactionnelle.

Selon un mode particulier de réalisation de l'invention, le procédé de dépôt peut être conduit par lots, de manière discontinue (dit "en batch"). Dans ce cas, la solution fille collectée à l'issue de l'étape c) est recueillie et déversée ultérieurement dans le réservoir d'alimentation, pour le traitement d'un nouveau substrat. Si ce traitement n'est pas réalisé immédiatement, la solution est placée dans un réservoir de stockage aux conditions de conservation satisfaisantes : l'étape c) de collecte de ladite fraction peut alors être suivie d'une étape c2) de stockage de la solution fille obtenue. Ce stockage est fait idéalement dans un récipient réfrigéré à l'abri de la lumière, sous atmosphère inerte, par exemple sous pression d'argon, ou d'un autre gaz sec ($N_2$ par exemple), pourvu qu'il ne soit pas oxydant.

La solution fille recueillie est moins concentrée en précurseur que ne l'était la solution mère initialement utilisée, de sorte que la quantité de précurseur collectée est généralement insuffisante pour réaliser une nouvelle opération de dépôt. Le précurseur doit alors être piégé (par exemple par condensation sélective) pendant au moins deux opérations de dépôt CVD pour avoir suffisamment de solution fille pour un nouveau dépôt d'une épaisseur similaire à celle obtenue lors de l'utilisation de la solution mère initiale qui est généralement d'au moins 1 $\mu$m d'épaisseur. Les solutions filles générées au cours de différentes opérations de dépôt peuvent être avantageusement recueillies, afin d'accumuler une quantité de précurseur suffisante pour alimenter le réservoir de solution mère pour une nouvelle opération de dépôt.

Avantageusement, on peut répéter séquentiellement N fois les étapes a) à c) du procédé de dépôt selon l'invention à l'issue desquelles les N solutions filles ont été recueillies, puis on réalise l'étape d) en déversant lesdites N solutions filles dans le réservoir d'alimentation pour obtenir une nouvelle solution mère apte à être utilisée à l'étape a).

Alternativement, selon un autre mode de réalisation particulier de l'invention, le procédé de dépôt est réalisé selon un mode discontinu tel que décrit précédemment, dans lequel les N solutions peuvent être stockées au fur et à mesure de leur collecte : l'étape d) est alors mise en œuvre ultérieurement.

Une fois que la quantité souhaitée de nouvelle solution mère recueillie est approximativement atteinte, sa concentration en précurseur peut être déterminée par analyse quantitative et éventuellement ajustée. Ensuite, le réservoir contenant la nouvelle solution mère peut être directement connecté au système d'injection pour une nouvelle opération de dépôt. Le cas échéant, le réacteur de dépôt CVD est nettoyé préalablement avec un solvant pur contenu dans un réservoir relié au système d'injection. Un des avantages des étapes c) et d) du procédé de dépôt de l'invention est ainsi de minimiser la perte de précurseur organométallique, ce qui améliore l'impact environnemental et diminue globalement le coût du procédé DLI-MOCVD.

En mode discontinu, le revêtement protecteur peut être avantageusement constitué de plusieurs couches de composition ou de nature différente, afin de former un revêtement protecteur multicouche hétérogène. Ce revêtement est alors généralement obtenu par un procédé qui réalise un dépôt séquencé de chaque monocouche déposée au cours d'un cycle du procédé de dépôt. Le dépôt de chaque couche peut ainsi être séparé par un temps de pause, compris par exemple entre 1 minute à 10 minutes. Cette pause peut être mise à profit pour purger le réacteur de dépôt chimique en phase vapeur.

Selon un autre mode de réalisation particulièrement intéressant d'un point de vue industriel, le procédé de dépôt de l'invention est réalisé en continu. Dans ce cas, on réutilise en boucle la solution fille obtenue à partir des espèces collectées, en particulier par condensation sélective. Ces espèces peuvent en effet être extraites en continu dans la fraction d'effluent gazeux collecté à l'étape c), car ce sont des composés de faible volatilité par rapport notamment aux sous-produits de décomposition des ligands aromatiques. Elles sont de ce fait aisément séparables, par exemple par condensation sélective dans un piège cryogénique.

Selon cette variante, la solution fille obtenue à l'étape c) est déversée en mode continu dans le réservoir d'alimentation, au cours du processus de dépôt chimique en phase vapeur. Les étapes c) et d) peuvent être pilotées par un système automatique pour assurer une boucle de circulation. Un dispositif permet de passer de la zone de basse pression au niveau du piège cryogénique, jusqu'au réservoir d'alimentation pressurisé, par une « chaîne » de variation de pression.

Le recyclage n'est pas universellement applicable dans un procédé de dépôt CVD car il est lié au système chimique que l'on met en œuvre. Il n'a été rendu possible dans le procédé de dépôt de l'invention que grâce à un choix spécifique et judicieux des précurseurs moléculaires associé à un dépôt de type DLI-MOCVD.

Les résultats satisfaisants obtenus sont d'autant plus étonnants que les caractéristiques chimiques et structurales des revêtements déposés sont identiques ou très proches, indépendamment de la composition du précurseur ou du solvant de la solution mère injectée, ce qui a été vérifié expérimentalement. Les propriétés physiques et mécaniques de ces revêtements sont également, sinon similaires du moins comparables. Finalement, et de manière inattendue, il a été démontré qu'il est possible d'augmenter très fortement le rendement du procédé de dépôt de l'invention, presque jusqu'à 100 %. Grâce à de tels rendements, des couches protectrices peuvent être déposées sur le substrat en continu avec le procédé de l'invention afin de former un revêtement protecteur d'épaisseur importante.

Ainsi, le revêtement protecteur peut avoir une épaisseur moyenne comprise entre 1 $\mu$m et 50 $\mu$m, de préférence entre 10 $\mu$m et 50 $\mu$m afin notamment de favoriser la protection du substrat.

Un revêtement protecteur monocouche ou multicouche (homogène ou hétérogène en composition) peut être déposé avec le procédé de dépôt de l'invention. Dans un revêtement protecteur monocouche ou multicouche, chaque couche protectrice peut avoir une épaisseur de 1 $\mu$m à 50 $\mu$m, encore plus préférentiellement de 1 $\mu$m à 25 $\mu$m, voire de 1 $\mu$m à 15 $\mu$m. Alternativement, au moins une couche protectrice peut avoir une épaisseur de 10 $\mu$m à 50 $\mu$m.

Le revêtement protecteur peut comprendre de 1 à 50 couches protectrices.

Outre l'amélioration de l'impact environnemental résultant d'un rejet quasi nul de composés organométalliques, le coût du procédé est fortement réduit en économisant du précurseur organométallique qui contribue de façon significative au coût global.

Il peut être intéressant de valoriser les solutions élaborées à partir des effluents collectés à l'issue du procédé de dépôt de l'invention. En effet, ces solutions sont de composition complexe et elles sont des sources de précurseur pour des traitements de surface par DLI-MOCVD. Comme précédemment indiqué, elles peuvent soit être utilisées en boucle directement dans le procédé dont elles proviennent, soit conservées pour une utilisation ultérieure. Au-delà des avantages déjà mentionnés, elles revêtent à ce titre un intérêt commercial propre. C'est le cas en particulier, en ce qui concerne les précurseurs organométalliques de type bis(arène)chrome qui sont réputés sensibles à l'air et à l'humidité. Par contre, ils sont moins réactifs à l'atmosphère lorsqu'ils sont en solution. Les solutions recyclées ont donc de ce fait un effet protecteur vis-à-vis du précurseur.

Le procédé de l'invention permet de déposer un revêtement de protection qui peut être réalisé sous une forme monolithique ou nanostructurée, en multicouches de même nature ou non. Il peut être déposé sur différents substrats métalliques (alliages, ...), céramiques (carbures), ou métalloïdes (silicium polycristallin par exemple), ou d'autres matériaux encore, du moment qu'ils sont aptes à supporter un traitement thermique à une température comprise entre 300 °C et 600 °C, ou au moins à environ 550 °C. Ces substrats sont destinés à divers domaines industriels, tels que par exemple ceux de l'outillage, de l'automobile, de l'aéronautique, de la microélectronique, des technologies liées à l'énergie telles que par exemple le photovoltaïque.

Ainsi, selon l'invention, ledit substrat à recouvrir peut être une pièce en métal (à savoir généralement composée en totalité ou essentiellement de métal natif), en alliage, en céramique ou en silicium. Le substrat peut aussi être fait d'un autre matériau supportant un traitement thermique à environ 550 °C.

D'autres objets, caractéristiques et avantages de l'invention vont maintenant être précisés dans la description qui suit de modes de réalisation particuliers du procédé de l'invention, donnés à titre illustratif et non limitatif, en référence aux Figures annexées.

## BREVE DESCRIPTION DES FIGURES

La Figure 1 montre les spectres UV-Visible en transmittance de lames de quartz sans dépôt (Blanc) et après traitement à 500 °C, 600 °C, 750 °C et 800 °C lors de l'injection de toluène seul (sans précurseur bis(éthylbenzène)chrome).

La Figure 2 présente l'évolution de l'intensité de l'absorbance à la longueur d'onde de 500 nm mesurée sur les spectres en transmittance de la Figure 1 en fonction de la température de pyrolyse.

La Figure 3 représente une droite d'étalonnage pour le BEBC en spectrophotométrie UV-visible.

La Figure 4 présente une comparaison des microstructures du revêtement obtenu avec du précurseur neuf et du précurseur recyclé (vues en coupe).

La Figure 5 présente une comparaison des microstructures du revêtement obtenu avec du précurseur neuf et du recyclé (vues de dessus).

La Figure 6 présente une comparaison des Spectres à Dispersion d'Energie (EDS) du revêtement obtenu avec du précurseur neuf (en haut) et du recyclé (en bas).

La Figure 7 présente une comparaison des diffractogrammes de rayons X d'un revêtement en carbures de chrome amorphes obtenu avec du précurseur neuf (en haut) et du précurseur recyclé (en bas).

La Figure 8 est une vue schématique d'un dispositif de DLI-MOCVD adapté à la mise en œuvre du procédé de dépôt de l'invention.

## EXPOSE DE MODES DE REALISATION PARTICULIERS

Les modes de réalisation particuliers du procédé de l'invention portent sur le dépôt de revêtements à base de chrome (carbures de chrome ou de chrome métallique) par décomposition des deux précurseurs BBC ou BEBC, dans le toluène pris comme solvant.

## EXEMPLE 1 : DEPOT DE CARBURE DE CHROME

Le dépôt d'un revêtement de carbure de chrome CrC a été réalisé dans les conditions suivantes :

Conditions d'injection :

- temps d'ouverture de l'injecteur : 0,5 ms
- fréquence : 10 Hz

Réactif : BEBC (5 g)
Solvant : Toluène (50 mL)
Gaz porteur : $N_2$ (débit de 500 sccm, à savoir 500 cm3/min sous des conditions standard)
Durée du dépôt : 20 minutes
Température de dépôt dans le réacteur : 450 °C ;
Pression de dépôt : 50 Torr
Température de vaporisation dans l'évaporateur : 200 °C
Température du piège cryogénique : -120 °C
Quantité de solution fille récupérée : 30 mL

Deux expériences N1 et N2 ont été réalisées avec une solution mère de BEBC. A l'issue de ces expériences, deux solutions filles sont collectées par piégeage cryogénique d'une fraction de l'effluent gazeux récupéré en sortie du réacteur CVD.

Dans une troisième expérience, les deux solutions filles récupérées sont réunies pour former une solution mère recyclée qui a été utilisée en tant que source de précurseur pour réaliser une troisième opération de dépôt N3.

Pour N1 et N2, l'épaisseur du dépôt est typiquement de 5 $\mu$m. Un dépôt d'environ 1,5 $\mu$m d'épaisseur est obtenu à l'issue de N3. La concentration en BEBC a été déterminée et le rendement calculé pour N1 et N2 (voir Tableau 1).

Tableau 1

| n° | solution injectée (ml) | [BEBC] dans la solution injectée (g/ml) | solution fille récupérée (ml) | [BEBC] dans la solution fille (g/ml) | rendement par rapport au précurseur (%) |
|---|---|---|---|---|---|
| N1 | 55 | 0,078 | 30 | 0,031 | 60 % |
| N2 | 50 | 0,083 | 30 | 0,034 | 59 % |
| N3 | 30+30 | 0,040 | 35 | Pas mesurée, car très faible | N/A |

## EXEMPLE 2 : DEPOT DE CHROME METALLIQUE AVEC RECYCLAGE DU PRECURSEUR

Le dépôt d'un revêtement de chrome métallique Cr a été réalisé dans les conditions suivantes :

Conditions d'injection :

- temps d'ouverture de l'injecteur 0,5 ms

- fréquence 10 Hz

Réactif : BEBC (5 g)
Solvant : Toluène (50 mL)
Additif : Thiophénol $C_6H_5SH$ (rapport molaire additif/précurseur = 2 %)
Gaz porteur : $N_2$ (débit 500 sccm)
Durée du dépôt : 1h
Température de dépôt dans le réacteur : 450 °C ;
Pression de dépôt : 50 Torr
Température de vaporisation dans l'évaporateur : 200 °C
Température du piège cryogénique : -100 °C.
Quantité de solution fille récupérée : 30 mL

Deux expériences ont été nécessaires pour récupérer 60 mL de solution fille. La solution mère ainsi recyclée a été réinjectée dans le réacteur CVD pour réaliser une troisième opération de dépôt sous les mêmes conditions : un revêtement protecteur d'environ 1 μm est obtenu.

## EXEMPLE 3 : CHOIX D'UN SOLVANT : LE TOLUENE

Afin d'étudier si le toluène peut être utilisé comme solvant dans le procédé selon l'invention, il a été vérifié qu'il ne se décompose pas dans la gamme de températures balayées par le procédé et dans des conditions hydrodynamiques comparables aux conditions réelles de dépôts par DLI-MOCVD.

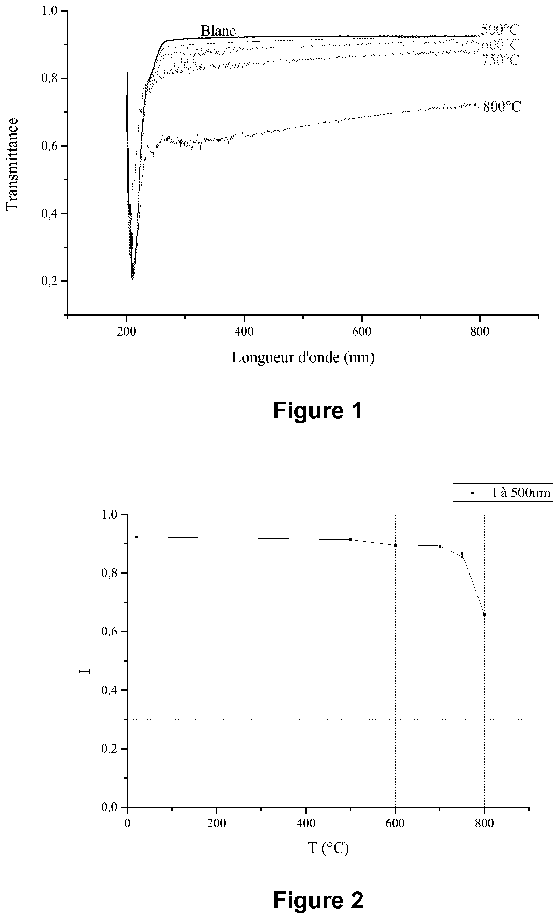

Des essais ont été réalisés en injectant uniquement du toluène dans le réacteur CVD. Des lames de quartz sont placées dans l'enceinte du réacteur CVD sur un porte-échantillon et après chaque dépôt, un spectre de transmittance UV-Visible a été enregistré. Plusieurs températures du réacteur ont été testées entre 500 °C et 800 °C. Les spectres obtenus sont présentés à la Figure 1. Le spectre d'une lame témoin, n'ayant pas subi de dépôt de carbone est aussi représenté (Blanc).

La transmittance moyenne à la longueur d'onde de 500 nm a été relevée pour les différentes températures du réacteur. Au-dessus de 600 °C, elle décroît car la lame de quartz s'opacifie suite à la formation d'un film mince de carbone. Il est légitime de penser que le toluène commence à se décomposer à cette température, avec une accentuation à 750 °C, plus marquée encore vers 800 °C comme le montre la Figure 2.

Par conséquent, le toluène est un solvant approprié pour des dépôts dont la température ne dépasse pas 600 °C.

De plus, ce résultat laisse penser que lorsqu'un précurseur bis(arène)chrome se décompose en libérant des ligands benzène, ceux-ci ne se décomposent pas non plus en dessous de 600 °C en phase homogène.

## EXEMPLE 4 : DOSAGE DES PRECURSEURS

De nombreuses techniques existent pour connaître la concentration en précurseur des solutions utilisées, toutes plus ou moins fiables et lourdes à mettre en œuvre. La concentration en précurseur de la solution mère injectée initialement dans le réacteur CVD de dépôt est connue. La concentration de la solution fille recyclée est à déterminer.

Pour cela, la concentration du BBC et du BEBC est déterminée par l'évolution de leur bande d'absorption à 315 nm dans le domaine UV qui est suivie par spectrophotométrie (Douard, A., in Institut Carnot CIRIMAT. 2006, INP Toulouse). Cette bande d'absorption correspond à la transition de transfert de charge $M(4e2g) \rightarrow L(5e2g)$, engendrée par la liaison chrome-ligand de la molécule de précurseur, liaison qui sera rompue dans la phase initiale du mécanisme de croissance du revêtement.

Le principe en est le suivant. La loi de Beer-Lambert, reliant la concentration à l'absorbance est :

$$A = \varepsilon * C * l,$$

avec

A : l'absorbance de la solution à 315 nm ;
$\varepsilon$ : le coefficient d'extinction molaire du précurseur ;
C : la concentration en précurseur ;
l : la longueur de la cuve.

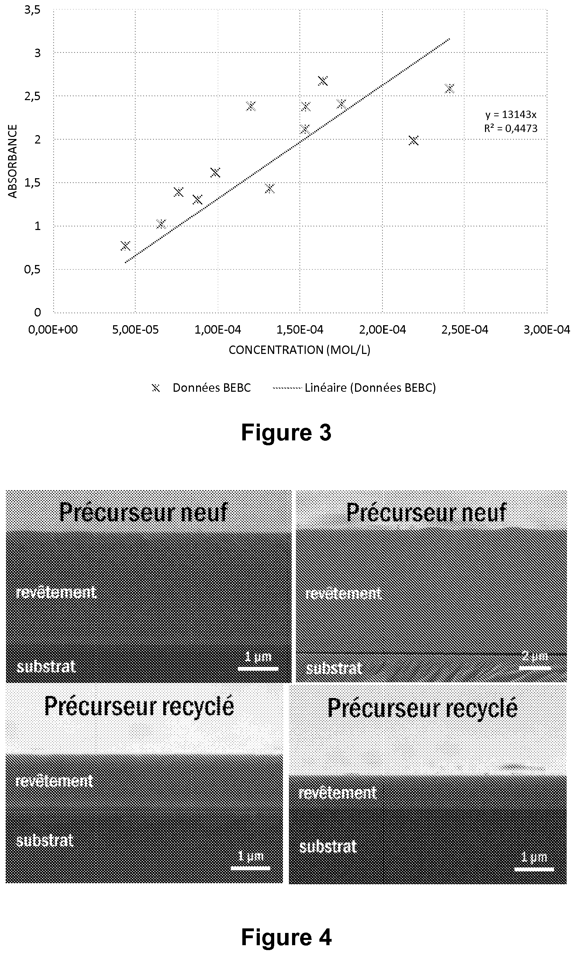

Afin de construire une droite d'étalonnage, des concentrations connues de solutions de BEBC ou BBC sont reliées à la mesure de leur absorbance (voir la Figure 3). La concentration de n'importe quelle solution peut ensuite être déterminée par spectrophotométrie UV-visible : son absorbance mesurée est directement reliée à sa concentration à l'aide de la droite d'étalonnage.

L'accès aux rendements du piège cryogénique du réacteur CVD est également possible. En prélevant un petit volume de solution fille en sortie de réacteur, sa concentration peut être déterminée afin de décider si nécessaire d'enrichir la solution fille en précurseur pour la réinjecter ensuite dans le système. L'absorbance de la solution fille peut aussi être mesurée en ligne en intégrant une cuve optique dans le circuit de récupération de la solution fille : c'est une méthode d'analyse non destructrice.

## EXEMPLE 5 : REVETEMENTS OBTENUS SUR DIVERS SUBSTRATS

Aucun mécanisme élémentaire précis n'a été avancé pour rendre compte de la croissance de carbures de chrome ou de chrome métallique par décomposition du précurseur BBC ou BEBC, pas plus que n'a été expliquée l'influence de la présence du toluène sur le mécanisme réactionnel. En outre, les données disponibles pour des températures de travail inférieures à 600 °C sont très rares.

Il a été démontré expérimentalement que le procédé de l'invention permet de déposer des films et revêtements protecteurs présentant les caractéristiques voulues.

## A) Les caractéristiques des films ne dépendent pas de la concentration en précurseur de la solution injectée.

De nombreuses variations dans les paramètres peuvent faire varier la concentration en précurseur de la solution injectée, et par extension celle de la phase gazeuse réactive envoyée dans le réacteur. Les films déposés par le procédé de l'invention sont néanmoins comparables. Les paramètres suivants ont ainsi été testés :

- Nature du précurseur utilisé : BEBC ;
- Paramètres d'injection modulant la proportion de solution injectée par rapport au débit de gaz porteur : fréquence entre 1 Hz et 20 Hz ; temps d'ouverture entre 0,5 ms et 5 ms ;
- Quantités relatives de précurseur et de solvant : concentrations en précurseur de $1,0 \times 10^{-2}$ mol.$L^{-1}$ à $5,0 \times 10^{-1}$ mol.$L^{-1}$.

Le fait d'injecter une solution à base de précurseur neuf et une solution à base de précurseur recyclé ne change pas les caractéristiques des films (voir ci-après). Les compositions des revêtements protecteurs obtenus, de type carbures de chrome amorphes, de composition proche de $Cr_7C_3$ sont en effet toujours semblables. Les morphologies sont aussi équivalentes, avec une microstructure typique d'un film amorphe, homogène, une couche protectrice complètement dense et très lisse.

Le dosage colorimétrique par spectrophotométrie a permis de mesurer que la solution mère à base de précurseur recyclé était environ 60 % moins concentrée en précurseur que la solution mère à base de précurseur neuf, sans impacter la qualité des films déposés.

D'autre part, le fait que ces caractéristiques sont indépendantes du rapport précurseur/solvant est cohérent avec des résultats antérieurs qui ont montré que des dépôts MOCVD (sans solvant) sont également comparables, tout comme des dépôts DLI-MOCVD (avec solvant) avec du cyclohexane à la place du toluène. Cela est cohérent avec le fait que le solvant n'intervient pas dans le mécanisme de décomposition du précurseur et qu'il n'est pas lui-même décomposé durant le procédé.

## B) Morphologie, microstructure (MEB, rugosité)

Les microstructures des revêtements protecteurs obtenus à partir de solution mère neuve ou recyclée sont en tous points similaires lors des observations en Microscopie Electronique à Balayage (MEB). Chaque revêtement est dense, compact et homogène en épaisseur sur toute la surface de l'échantillon, comme montré en Figure 4.

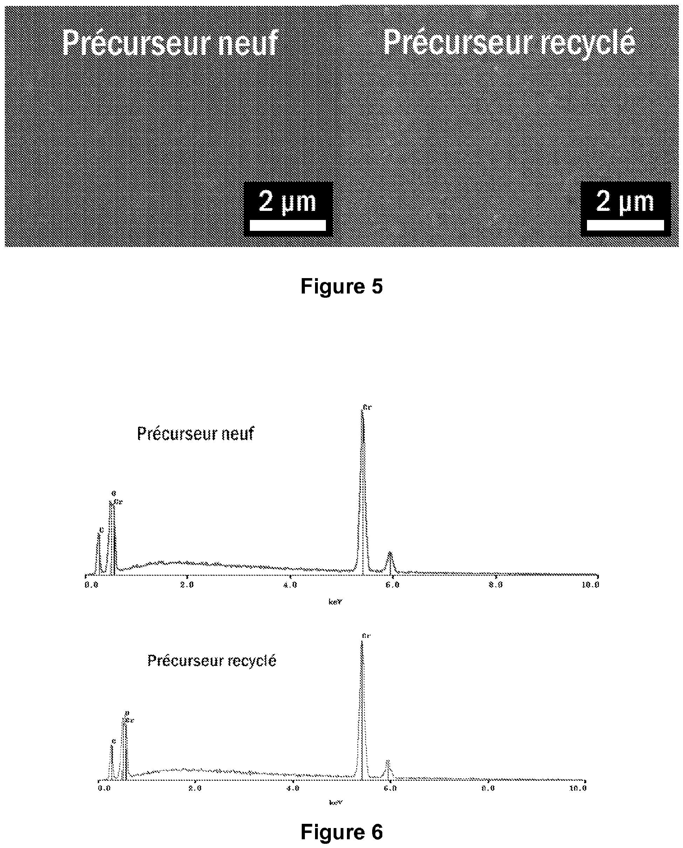

L'interface avec le substrat Si est bien délimitée. De plus, en vue de dessus (voir Figure 5), ils ont le même aspect très lisse sans hétérogénéités majeures mais avec quelques éléments de pollution de surface. Les épaisseurs maximales atteintes avec le précurseur neuf sont significativement plus grandes que celles avec le précurseur recyclé, car la concentration de la solution recyclée était plus faible. Beaucoup de précurseur étant consommé dans le réacteur, uniquement une petite partie est récupérée grâce au piège cryogénique.

## C) Composition (EDS, EPMA)

Les spectres EDS sont aussi comparables, avec une légère pollution à l'oxygène visible dans les deux cas, précurseur neuf ou précurseur recyclé. Les pics du chrome et du carbone ont des intensités identiques, comme le montrent les spectres en Figure 6.

Les compositions élémentaires trouvées avec les analyses par microsonde de Castaing ((dite « EPMA » en anglais pour « Electron Probe MicroAnalysis »)) ne révèlent aucune disparité flagrante entre les échantillons préparés avec le précurseur neuf ou recyclé :

- BEBC - 500 °C (amorphe) : $Cr_{0,65}C_{0,32}O_{0,03}$ normalisé à $Cr_{0,67}C_{0,33}$ et C/Cr = 0,49
- BEBC - 450 °C (amorphe) : $Cr_{0,64}C_{0,33}O_{0,03}$ normalisé à $Cr_{0,66}C_{0,34}$ et C/Cr = 0,52
- BEBC recyclé - 450 °C (amorphe) : $Cr_{0,64}C_{0,30}O_{0,05}$ normalisé à $Cr_{0,68}C_{0,32}$ et C/Cr = 0,48

Pour rappel, le rapport C/Cr vaut 0,43 pour $Cr_7C_3$ et 0,66 pour $Cr_3C_2$. La composition moyenne observée est donc très proche de $Cr_7C_3$.

## D) Structure (DRX)

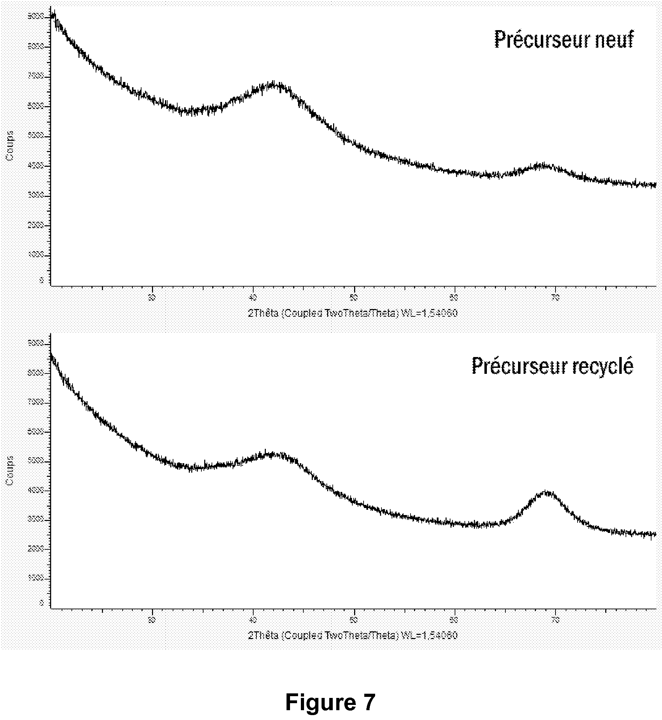

L'analyse par Diffraction de Rayons X (DRX) montre que les revêtements sont toujours amorphes, comme l'atteste la bosse large qui est centrée vers $2\theta$ = 42°. Des exemples de diffractogrammes obtenus pour un dépôt à partir de précurseur neuf et recyclé sont présentés en Figure 7. La bosse large centrée autour de $2\theta$ = 69° est caractéristique de la couche amorphe a-$Si_3N_4$ qui sert de barrière sur le substrat en silicium. Elle est présente sur les substrats nus, et sa contribution est plus forte lorsque le dépôt est plus mince (cas de la solution mère contenant du précurseur recyclé).

## E) Propriétés mécaniques : Dureté (nano-indentation)

La machine de nano-indentation est munie d'un indent de type Berkovich (pyramide à base triangulaire avec un angle de 65,27° entre la verticale et la hauteur d'une des faces de la pyramide). Les mesures sont faites dans le respect de la règle du dixième : enfoncement de l'indent de moins d'un dixième de l'épaisseur du revêtement. Un cycle de mesure se fait en trois temps :

- Charge croissante jusqu'à la charge maximale, en 30 s ;
- Maintien de la charge maximale pendant 30 s ;
- Décharge pendant 30 s.

Les mesures de nano-indentation ont été faites sur des échantillons revêtus à partir de précurseur neuf (3,5 $\mu$m d'épaisseur) et recyclé (1 $\mu$m d'épaisseur). Les calculs effectués par le logiciel de mesure et d'analyse prennent en compte un coefficient de Poisson du revêtement de 0,2. Les mesures de duretés et de module d'Young sont présentées dans le Tableau 2.

Les valeurs trouvées pour le revêtement déposé à partir de précurseur recyclé sont plus élevées pour la dureté, mais plus faibles en ce qui concerne le module d'Young. Elles restent en tout cas cohérentes avec des valeurs attendues d'un revêtement très dur.

Tableau 2

| Échantillon | Dureté (GPa) | Module (GPa) | Charge (mN) | Enfoncement (nm) en proportion avec l'épaisseur |
|---|---|---|---|---|
| | 25 | 294 | 4 | |
| CrC 3,5 $\mu$m | 21 | | | ~ 100 (3 %) |
| | 21 | 292 | 3 | |
| | 24 | 280 | | |
| **Moyenne** | **23** | **291** | | |

(suite)

| Échantillon | Dureté (GPa) | Module (GPa) | Charge (mN) | Enfoncement (nm) en proportion avec l'épaisseur |
|---|---|---|---|---|
| | 32 | 260 | | |
| CrC 1 μm "recyclé" | 33 | 279 | 3 | ~ 90 (9 %) |
| | 26 | 240 | | |
| | 31 | 257 | | |
| **Moyenne** | **31** | **259** | | |

## EXEMPLE 6 : DISPOSITIF DE DÉPÔT PAR DLI-MOCVD

Un dispositif de dépôt par DLI-MOCVD qui peut convenir pour la mise en œuvre des étapes de dépôt a) et b) du procédé de l'invention est par exemple décrit dans ses principales caractéristiques dans le document WO 2008009714.

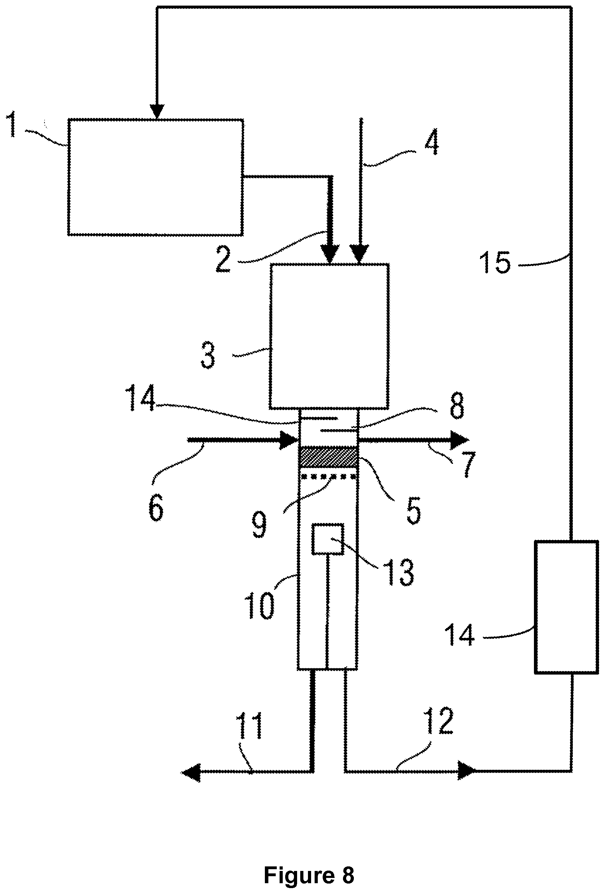

Le dispositif de DLI-MOCVD qui peut être utilisé pour le dépôt du revêtement protecteur avec le procédé de dépôt de l'invention selon les étapes a) à d) comprend principalement un réservoir d'alimentation, un évaporateur, un injecteur, un réacteur CVD et une unité pour collecter la solution fille en vue de son recyclage dans le dispositif. Ce dispositif de DLI-MOCVD est décrit plus précisément en référence à la Figure 8.

Un réservoir d'alimentation pressurisé 1 alimente l'injecteur 2 en solution mère. L'injecteur 2 est constitué le plus souvent d'un système d'injection pulsé du commerce, par exemple un injecteur automobile diesel.

L'ouverture et la fermeture de l'injecteur 2 peuvent être contrôlées par informatique, ce qui permet l'injection de la solution mère dans l'évaporateur 3.

L'évaporateur 3 est positionné co-axialement au-dessus de la chambre de dépôt CVD 10 généralement verticale dans laquelle il débouche.

Une ligne d'alimentation en gaz vecteur 4 débouche dans l'évaporateur 3 à côté de la sortie de l'injecteur 2. Le flux de gaz vecteur entraîne la solution mère vaporisée de l'évaporateur 3 vers la chambre de dépôt CVD 10. A l'entrée de cette dernière, une chicane 8 arrête les éventuelles gouttelettes non vaporisées à la sortie de l'évaporateur 3 et une grille 9 percée de trous distribue uniformément le flux gazeux. Cette grille 9 permet une bonne répartition du flux gazeux dans la chambre de dépôt CVD 10, ce qui contribue à l'obtention d'un bon état de surface des revêtements et une uniformité d'épaisseur.

Une vanne tiroir 5 peut isoler l'évaporateur 3 du reste de la chambre de dépôt CVD 10 : le volume ainsi délimité en dessous de la vanne tiroir 5 comprend le réacteur CVD proprement dit dans lequel se trouve le suscepteur 13 sur lequel est placé le substrat à recouvrir.

La canalisation annexe 6 au-dessus de la vanne tiroir 5, permet l'arrivée d'un gaz réactif tel que par exemple un inhibiteur d'incorporation de carbone. La canalisation annexe 7 au-dessus de la vanne tiroir 5 permet le pompage de l'évaporateur 3 pendant les cycles de purge ou de nettoyage de ce dernier. La bride 14 sur laquelle sont effectués les piquages des canalisations annexes 6 et 7, ainsi que la vanne tiroir 5 en entrée du réacteur CVD, sont chauffées à une température proche de celle de l'évaporateur 3.

Une couche protectrice est déposée sur le substrat à partir de la solution mère vaporisée dans le réacteur CVD.

A l'issue de cette réaction de dépôt par DLI-MOCVD, un exutoire 12 en sortie de la chambre de dépôt CVD 10 collecte une fraction de l'effluent gazeux produit lors de la réaction. Cette fraction comprend le précurseur de type bis(arène) non consommé, les sous-produits aromatiques du précurseur et le solvant, voire le cas échéant l'inhibiteur d'incorporation de carbone.

L'exutoire 12 débouche sur une unité de condensation sélective 14 (telle que par exemple un piège cryogénique), dans laquelle les principaux composés indésirables (en particulier les hydrocarbures légers) de la fraction de l'effluent gazeux sont éliminés afin de produire une solution fille.

Lorsque le procédé de dépôt de l'invention est réalisé en mode continu, une conduite 15 achemine en continu la solution fille ainsi produite pour la recycler dans le réservoir d'alimentation 1. Une nouvelle solution mère est alors formée en vue de son utilisation dans un nouveau cycle du procédé de dépôt de l'invention.

Une pompe primaire 11 peut être utilisée pour purger l'ensemble du dispositif de DLI-MOCVD, par exemple avant un nouveau dépôt.

**Revendications**

1. Procédé de dépôt sur un substrat d'un revêtement protecteur composé d'une ou de plusieurs couches, l'une au moins étant une couche protectrice comprenant un métal de transition M sous forme d'au moins une matière protectrice choisie parmi un carbure, un alliage ou le métal de transition M sous forme native, le procédé de dépôt étant un procédé de dépôt chimique en phase vapeur d'un composé organométallique par injection liquide directe (DLI-MOCVD) qui comprend les étapes suivantes :

   a) disposer dans un réservoir d'alimentation d'une solution mère contenant :

   - un solvant hydrocarboné dépourvu d'atome d'oxygène,
   - ledit composé organométallique constitué d'un précurseur de type bis(arène) ayant une température de décomposition comprise entre 300 °C et 600 °C et comprenant le métal de transition M, et
   - le cas échéant un inhibiteur d'incorporation de carbone ;

   b) vaporiser ladite solution mère dans un évaporateur puis l'introduire dans un réacteur de dépôt chimique en phase vapeur dans lequel se trouve ledit substrat à recouvrir ; pour réaliser, dans l'enceinte du réacteur dont l'atmosphère est à une température de dépôt comprise entre 300 °C et 600 °C sous pression de dépôt réduite, le dépôt de la couche protectrice sur ledit substrat ;
   c) collecter en sortie du réacteur une fraction de l'effluent gazeux comprenant le précurseur non consommé, les sous-produits aromatiques du précurseur et le solvant, ces espèces formant ensemble dans les conditions standards une solution fille, et ;
   d) déverser la solution fille ainsi obtenue dans le réservoir d'alimentation pour obtenir une nouvelle solution mère apte à être utilisée à l'étape a).

2. Procédé selon la revendication 1, dans lequel l'étape b) de vaporisation et dépôt et l'étape c) de collecte de ladite fraction de l'effluent sont réalisées de telle sorte que l'atmosphère de l'enceinte du réacteur est à une pression de dépôt réduite comprise entre 133 Pa et 6666 Pa.

3. Procédé selon la revendication 1 ou 2, dans lequel le métal de transition M est choisi parmi Cr, Nb, V, W, Mo, Mn ou Hf.

4. Procédé selon la revendication précédente, dans lequel le métal de transition M est au degré d'oxydation zéro.

5. Procédé selon la revendication 3 ou 4, dans lequel le carbure du métal de transition M composant la matière protectrice est de type CrC, WC, NbC, MoC, VC ou HfC, ou a pour formule stœchiométrique $Cr_7C_3$, $Cr_3C_2$, $Mo_2C$, $Mn_3C$, $V_2C$ ou $V_4C_3$.

6. Procédé selon l'une quelconque des revendications 3 à 5, dans lequel l'alliage du métal de transition M composant la matière protectrice est un alliage de base du métal de transition M.

7. Procédé selon l'une quelconque des revendications précédentes, dans lequel le précurseur de type bis(arène) est dépourvu d'atome d'oxygène et a pour formule générale (Ar)(Ar')M où M est le métal de transition au degré d'oxydation zéro ($M_0$) et Ar, Ar', identiques ou différents, représentent chacun un groupe aromatique de type benzène ou benzène substitué par au moins un groupe alkyl.

8. Procédé selon la revendication précédente, dans lequel les groupes aromatiques Ar et Ar' représentent chacun un radical benzène, ou benzène substitué par un à trois groupes identiques ou différents choisis parmi un groupe méthyl, éthyl, ou isopropyl.

9. Procédé selon l'une quelconque des revendications précédentes, dans lequel le solvant est un hydrocarbure aromatique monocyclique de formule générale CxHy, liquide dans les conditions standards, ayant une température d'ébullition inférieure à 150 °C et une température de décomposition supérieure à 600 °C.

10. Procédé selon l'une quelconque des revendications précédentes, dans lequel ladite solution mère contient en outre, en tant qu'inhibiteur d'incorporation de carbone, un additif chloré ou soufré, dépourvu d'atome d'oxygène et dont la température de décomposition est supérieure à 600 °C, afin d'obtenir la matière protectrice composée du métal de transition M ou de l'alliage du métal de transition M.

11. Procédé selon l'une quelconque des revendications précédentes, dans lequel, à l'étape c), la collecte de ladite fraction comprend une opération de condensation sélective des espèces présentes dans l'effluent en sortie du réacteur.

12. Procédé selon l'une quelconque des revendications précédentes, dans lequel l'étape c) de collecte de ladite fraction est suivie d'une étape c1) de détermination de la concentration du précurseur dans la solution fille obtenue ; et l'étape d) comprend une opération d0) d'ajustement de la concentration du précurseur, en fonction de la concentration du précurseur de la solution fille déversée dans le réservoir d'alimentation.

13. Procédé selon l'une quelconque des revendications précédentes, dans lequel on répète séquentiellement N fois les étapes a) à c) et on recueille les N solutions filles, puis on réalise l'étape d) en déversant lesdites N solutions filles dans le réservoir d'alimentation pour obtenir une nouvelle solution mère apte à être utilisée à l'étape a).

14. Procédé selon l'une quelconque des revendications précédentes, dans lequel la solution fille obtenue à l'étape c) est déversée en mode continu dans le réservoir d'alimentation, au cours du processus de dépôt chimique en phase vapeur.

15. Procédé selon l'une quelconque des revendications précédentes, dans lequel le revêtement protecteur a une épaisseur moyenne comprise entre 1 $\mu$m et 50 $\mu$m.

**Patentansprüche**

1. Verfahren zur Abscheidung einer Schutzbeschichtung aus einer oder mehreren Schichten auf einem Substrat, wobei mindestens eine davon eine Schutzschicht ist, die ein Übergangsmetall M in Form mindestens eines Schutzmaterials umfasst, das aus einem Carbid, einer Legierung oder dem Übergangsmetall M in nativer Form ausgewählt ist, wobei das Abscheidungsverfahren ein Verfahren zur chemischen Gasphasenabscheidung einer metallorganischen Verbindung durch direkte Flüssigkeitsinjektion (DLI-MOCVD) ist, das die folgenden Schritte umfasst:

   a) Bereitstellen einer Vorratslösung in einem Nachfüllbehälter, wobei die Lösung Folgendes enthält:

      - ein sauerstoffatomfreies Kohlenwasserstofflösungsmittel,
      - die metallorganische Verbindung, die aus einem Vorläufer vom Bis(aren)-Typ besteht, eine Zersetzungstemperatur zwischen 300 °C und 600 °C aufweist und das Übergangsmetall M umfasst, und
      - gegebenenfalls einen Inhibitor des Kohlenstoffeinbaus;

   b) Verdampfen der Vorratslösung in einem Verdampfer und anschließendes Einbringen in einen Reaktor zur chemischen Gasphasenabscheidung, in dem sich das zu beschichtende Substrat befindet, um in der Kammer des Reaktors, dessen Atmosphäre eine Abscheidungstemperatur zwischen 300 °C und 600 °C unter vermindertem Abscheidungsdruck aufweist, die Abscheidung der Schutzschicht auf dem Substrat auszuführen;
   c) Sammeln, am Auslass des Reaktors, einer Fraktion des gasförmigen Abstroms, die den nicht verbrauchten Vorläufer, die aromatischen Nebenprodukte des Vorläufers und das Lösungsmittel umfasst, wobei diese Spezies unter Normalbedingungen zusammen eine Arbeitslösung bilden, und
   d) Einleiten der so erhaltenen Arbeitslösung in den Nachfüllbehälter, um eine neue Vorratslösung zu erhalten, die zur Verwendung in Schritt a) geeignet ist.

2. Verfahren nach Anspruch 1, wobei der Schritt b) des Verdampfens und Abscheidens und der Schritt c) des Sammelns der Fraktion des Abstroms derart ausgeführt werden, dass sich die Atmosphäre der Reaktorkammer auf einem verminderten Abscheidungsdruck zwischen 133 Pa und 6666 Pa befindet.

3. Verfahren nach Anspruch 1 oder 2, wobei das Übergangsmetall M aus Cr, Nb, V, W, Mo, Mn oder Hf ausgewählt ist.

4. Verfahren nach dem vorhergehenden Anspruch, wobei sich das Übergangsmetall M im Oxidationszustand null befindet.

5. Verfahren nach Anspruch 3 oder 4, wobei das Carbid des Übergangsmetalls M, aus dem das Schutzmaterial besteht, vom Typ CrC, WC, NbC, MoC, VC oder HfC ist oder die stöchiometrische Formel $Cr_7C_3$, $Cr_3C_2$, $Mo_2C$, $Mn_3C$, $V_2C$ oder $V_4C_3$ aufweist.

6. Verfahren nach einem der Ansprüche 3 bis 5, wobei die Legierung des Übergangsmetalls M, aus der das Schutzmaterial besteht, eine Basislegierung des Übergangsmetalls M ist.

7. Verfahren nach einem der vorhergehenden Ansprüche, wobei der Vorläufer vom Bis(aren)-Typ frei von Sauerstoffatomen ist und die allgemeine Formel (Ar)(Ar')M aufweist, wobei M das Übergangsmetall im Oxidationszustand null ($M_0$) ist und Ar, Ar', die gleich oder verschieden sein können, jeweils für eine aromatische Gruppe vom Typ Benzol oder mit mindestens einer Alkylgruppe substituiertes Benzol stehen.

8. Verfahren nach dem vorhergehenden Anspruch, wobei die aromatischen Gruppen Ar und Ar' jeweils für einen Benzolrest oder Benzol, das mit einer bis drei gleichen oder verschiedenen Gruppen, ausgewählt aus einer Methyl-, Ethyl- oder Isopropylgruppe, substituiert ist, stehen.

9. Verfahren nach einem der vorhergehenden Ansprüche, wobei das Lösungsmittel ein unter Normalbedingungen flüssiger monocyclischer aromatischer Kohlenwasserstoff der allgemeinen Formel CxHy mit einem Siedepunkt unter 150°C und einer Zersetzungstemperatur über 600 °C ist.

10. Verfahren nach einem der vorhergehenden Ansprüche, wobei die Vorratslösung außerdem als Inhibitor des Kohlenstoffeinbaus ein chlor- oder schwefelhaltiges Additiv enthält, das frei von Sauerstoffatomen ist und dessen Zersetzungstemperatur über 600 °C liegt, um das aus dem Übergangsmetall M oder der Legierung des Übergangsmetalls M bestehende Schutzmaterial zu erhalten.

11. Verfahren nach einem der vorhergehenden Ansprüche, wobei in Schritt c) das Sammeln der Fraktion eine selektive Kondensation der in dem Abstrom am Reaktorauslass vorhandenen Spezies umfasst.

12. Verfahren nach einem der vorhergehenden Ansprüche, wobei auf den Schritt c) des Sammelns der Fraktion ein Schritt c1) des Bestimmens der Konzentration des Vorläufers in der erhaltenen Arbeitslösung folgt und Schritt d) einen Vorgang d0) zum Einstellen der Konzentration des Vorläufers in Abhängigkeit von der Konzentration des Vorläufers in der in den Nachfüllbehälter eingeleiteten Arbeitslösung umfasst.

13. Verfahren nach einem der vorhergehenden Ansprüche, wobei die Schritte a) bis c) nacheinander N-mal wiederholt werden und N Arbeitslösungen aufgefangen werden und dann Schritt d) ausgeführt wird, indem die N Arbeitslösungen in den Nachfüllbehälter eingeleitet werden, um eine neue Vorratslösung zu erhalten, die zur Verwendung in Schritt a) geeignet ist.

14. Verfahren nach einem der vorhergehenden Ansprüche, wobei die in Schritt c) erhaltene Arbeitslösung während des Prozesses der chemischen Gasphasenabscheidung kontinuierlich in den Nachfüllbehälter eingeleitet wird.

15. Verfahren nach einem der vorhergehenden Ansprüche, wobei die Schutzbeschichtung eine mittlere Dicke zwischen 1 µm und 50 µm aufweist.

## Claims

1. Process for the deposition on a substrate of a protective coating composed of one or more layers, at least one being a protective layer comprising a transition metal M in the form of at least one protective material chosen from a carbide, an alloy or the transition metal M in native form, the deposition process being a process for the chemical vapor deposition of an organometallic compound by direct liquid injection (DLI-MOCVD) which comprises the following steps:

a) having available, in a feed tank, a mother solution containing:

- a hydrocarbon solvent devoid of oxygen atom,
- said organometallic compound composed of a precursor of bis(arene) type having a decomposition temperature of between 300 °C and 600 °C and comprising the transition metal M, and
- if appropriate, a carbon-incorporation inhibitor;

b) vaporizing said mother solution in an evaporator and then introducing it into a chemical vapor deposition reactor in which said substrate to be covered is found; in order to carry out, in the chamber of the reactor, the atmosphere of which is at a deposition temperature of between 300 °C and 600 °C under reduced deposition pressure, the deposition of the protective layer on said substrate;

c) collecting, at the outlet of the reactor, a fraction of the gaseous effluent comprising the unconsumed precursor, the aromatic byproducts of the precursor and the solvent, these entities together forming, under standard conditions, a daughter solution, and;

d) pouring the daughter solution thus obtained into the feed tank in order to obtain a new mother solution capable of being used in step a).

2. Process according to claim 1, wherein step b) of vaporizing and deposition and step c) of collecting said fraction of the effluent are carried out so that the atmosphere of the chamber of the reactor is at a reduced deposition pressure of between 133 Pa and 6666 Pa.

3. Process according to claim 1 or 2, wherein the transition metal M is chosen from Cr, Nb, V, W, Mo, Mn or Hf.

4. Process according to the preceding claim, wherein the transition metal M is at the zero oxidation state.

5. Process according to claim 3 or 4, wherein the carbide of the transition metal M composing the protective material is of CrC, WC, NbC, MoC, VC or HfC type, or has the stoichiometric formula $Cr_7C_3$, $Cr_3C_2$, $Mo_2C$, $Mn_3C$, $V_2C$ or $V_4C_3$.

6. Process according to any one of claims 3 to 5, wherein the alloy of the transition metal M composing the protective material is a base alloy of the transition metal M.

7. Process according to any one of the preceding claims, wherein the precursor of bis(arene) type is devoid of oxygen atom and has the general formula (Ar)(Ar')M, where M is the transition metal at the zero oxidation state ($M_0$) and Ar and Ar', which are identical or different, each represent an aromatic group of the type of benzene or benzene substituted by at least one alkyl group.

8. Process according to the preceding claim, wherein the aromatic groups Ar and Ar' each represent a benzene radical or a benzene radical substituted by from 1 to 3 identical or different groups chosen from a methyl, ethyl or isopropyl group.

9. Process according to any one of the preceding claims, wherein the solvent is a monocyclic aromatic hydrocarbon of general formula $C_xH_y$ which is liquid under the standard conditions and which has a boiling point of less than 150 °C and a decomposition temperature of greater than 600 °C.

10. Process according to any one of the preceding claims, wherein said mother solution further contains, as carbon-incorporation inhibitor, a chlorine-comprising or sulfur-comprising additive, devoid of oxygen atom and with a decomposition temperature of greater than 600 °C, in order to obtain the protective material composed of the transition metal M or of the alloy of the transition metal M.

11. Process according to any one of the preceding claims, wherein, in step c), the collecting of said fraction comprises an operation of selective condensation of the entities present in the effluent at the outlet of the reactor.

12. Process according to any one of the preceding claims, wherein step c) of collecting said fraction is followed by a step c1) of determination of the concentration of the precursor in the daughter solution obtained ; and the step d) comprises an operation d0) of adjustment of the concentration of the precursor, as a function of the concentration of the precursor of the daughter solution poured into the feed tank.

13. Process according to any one of the preceding claims, wherein steps a) to c) are repeated sequentially N times and the N daughter solutions are saved, and then step d) is carried out by pouring said N daughter solutions into the feed tank in order to obtain a new mother solution capable of being used in step a).

14. Process according to any one of the preceding claims, wherein the daughter solution obtained in step c) is poured continuously into the feed tank, during the chemical vapor deposition process.

15. Process according to any one of the preceding claims, wherein the protective coating has a mean thickness of between 1 μm and 50 μm.

**Figure 1**

**Figure 2**

**Figure 3**

**Figure 4**

Figure 5

Figure 6

**Figure 7**

**Figure 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008009714 A
- WO 2008009715 A

- WO 2007106462 A

**Littérature non-brevet citée dans la description**

- **WANG, Y. et al.** *ACS Nano,* 2011, vol. 5 (12), 9927-9933
- *International, R.,* 2010, http://www.recyclinginternational.com /recycling-news/3464/research-and-legislation/japan/japanese - recycling-process-ruthenium-precursors
- **PLATA, D.L. et al.** *Environmental Science & Technology,* 2009, vol. 43 (21), 8367-8373
- **COLLINGHAM, M.E. et al.** *Journal of the Electrochemical Society,* 1989, vol. 136 (3), 787-794
- Vent Gas Recovery and Recycle Process Technology Package, accessible sur le site. *Project, P.P.,* 2010, www.polyplantproject.com/offgasrecoveryrecycling.html

- **NODA, S. et al.** *Conference Record of the Twenty-Ninth IEEE,* 2002
- **F. MAURY ; A. DOUARD ; S. DELCLOS ; D. SAMELOR ; C. TENDERO.** *Multilayer chromium based coatings grown by atmospheric pressure direct liquid injection CVD Surface and Coatings Technology,* 2009, vol. 204, 983-987
- **A. DOUARD ; F. MAURY.** Nanocrystalline chromium-based coatings deposited by DLI-MOCVD under atmospheric pressure from Cr(CO)6. *Surface and Coatings Technology,* 2006, vol. 200, 6267-6271
- Handbook of Chemistry and Physics. CRC Press